# EUROPEAN PATENT APPLICATION

(11) **EP 2 928 271 A1**
(43) Date of publication of application: **07.10.2015**
(21) Application number: 14163552.4
(22) Date of filing: 04.04.2014
(51) Int. Cl.: H05K 1/02

(54) **Stretchable device for transmitting signal**

(71) Applicant: Clothing Plus MBU Oy, 38700 Kankaanpää (FI)
(72) Inventor: Ilkko, Aino-Maria, 38700 Kankaanpää (FI); Malmivaara, Heidi, 38700 Kankaanpää (FI); Jaakkola, Heikki, 38700 Kankaanpää (FI); Myry, Manu, 42840 Kolkki (FI)
(74) Representative: Berggren Oy Ab

(57) **Abstract**

A stretchable device (100) for transmitting signal between end points, such as a sensor and electronic unit, comprises a conductive element (101), which is coupled with a supporting structure (102) by introducing said conductive element (101) successively through the thickness of said supporting structure (102) to the first (102a) and second (102b) side of said supporting structure, thereby providing a corrugated structure for said conductive element, which is configured to be straighten out at least partially during stretching said device in its longitudinal direction. The conductive element (101) is coupled with said supporting structure (102) between first (104a) and second (104b) outer layers thereby providing the stretchable device (100).

## Description

### TECHNICAL FIELD OF THE INVENTION

The invention relates to a stretchable device for transmitting signal between two ends, such as between a sensor and electric unit or two or more electric units. In particularly the invention relates to a stretchable and wearable device for transmitting signal from the sensor measuring signals from the body surface of a user, such as pulse, EEG, temperature, acceleration or pulse oximeter as an example. In addition the invention relates to a method for manufacturing the device.

### BACKGROUND OF THE INVENTION

Stretchable devices for transmitting signals between two ends, such as a sensor and electric unit typically, comprise conductor or flexible circuit boards integrated into the stretchable material, such as textile. Anyway the first problem is that the conventional conductor or flexible circuit board is inextensible as such as this not stretchable. However, the stretchability of the device and especially of the conductors or circuit board is often achieved e.g. by corrugating the conductor or a flexible circuit board and fixing it partially here and there to the textile stretchable as such so that the corrugations are formed. When the textile is extended, the corrugations will be straighten out extending thereby the length of said conductor in the direction of extension force and again thereby providing stretchability, even if the actual length of the conductor is not increased as such.

There are however some disadvantages relating to the known devices, such as sharp angles can still be formed to the conductor or the conductor may be squashed, whereupon there is a high risk for mechanical and electrical breakages. In addition the devices do not easily shape along the curves or surfaces of a human body, for example, but the conductor or flexible circuit board tends to curve unstably when the body is moved or curved. This is mainly because for example the flexible circuit board bends quite easily in its longitudinal direction but is very rigid in its side direction (perpendicular to the longitudinal direction) and thus the bending in the side direction causes torque forces resulting said unwanted curve to the device. Moreover when the conductor is attached to the enclosure textile for example mechanically or chemically, there are again risks that the mechanical or chemical fastening breaks the structure of the conductor either mechanically or chemically. For example in sewing the needle may perforate the conductor or in using of chemical gluing the glue may corrode the conductor material.

### SUMMARY OF THE INVENTION

An object of the invention is to alleviate and eliminate the problems relating to the known prior art. Especially the object of the invention is to provide a stretchable device for transmitting signal between two points, such as between electric units or a sensor and electric unit, where said device is advantageously coupled with. In particularly the object of the invention is to achieve a soft, adaptive and comfortable stretchable device, the manufacturing process of which is fast and inexpensive, and where possible breakages of the conducting element of the device is minimized and thereby the life time is extended.

The object of the invention can be achieved by the features of independent claims.

The invention relates to a stretchable device for transmitting signal according to claim 1. In addition the invention relates to a method for manufacturing said device according to claim 14.

According to an embodiment of the invention a stretchable and advantageously wearable device for transmitting signal between end points, such as electric units or a sensor and electric unit, is provided. The sensor may be e.g. a sensor suitable for measuring bio signal, such as pulse meter or pulse oximeter, EEG sensor, temperature sensor or acceleration sensor, whereupon the signal is advantageously measured signal. The electric unit may be e.g. data processing or data transmitting unit or an energy source, like a battery or solar cell.

The device advantageously comprises a conductive element, such as conductor, circuit board, electric wire or cable or optical fibre or the like, and a supporting structure for supporting said conductive element. The supporting structure comprises advantageously a spacer or foam, for example, which might be stretchable as such, or alternatively it may be manipulated to be stretchable, such as making suitable openings, cuts, grooves or other incisions into the material of the supporting structure.

According to an embodiment the conductive element is coupled with the supporting structure by introducing the conductive element successively in a cross direction through or partially through a thickness of the supporting structure towards a first and second side of the supporting structure. In this way a corrugated structure can be achieved for the conductive element in the device, which is configured to be straighten out at least partially during stretching the device for example in its longitudinal direction, which is essentially in perpendicular to said thickness.

According to an embodiment the conductive element is coupled with the supporting structure by reeving the conductive element successively through the whole supporting structure to first and second sides of the supporting structure, thereby providing said corrugated structure for said conductive element.

The conductive element can be coupled with the supporting structure also other ways. One example is to provide openings or cuts to the supporting structure extending through the whole thickness of said supporting structure to the first and second side of said supporting structure and introducing said conductive element successively through the whole thickness of said supporting structure to the first and second side via said openings or cuts. According to an embodiment the supporting structure may comprise a number of structure members, which are coupled together so to form the supporting structure. The conductive element can then be introduced successively from side to side of the supporting structure via the joints between the structure members coupled with each other.

In addition, according to an embodiment supporting structure may be formed of at least two structure members coupled together so to form the supporting structure. The joint surfaces of the structure members comprises protrusions essentially in the cross direction through the thickness of said supporting structure (towards a first and second side of said supporting structure). The conductive element can then be arranged into the joint area between the structure members and thereby providing a corrugated structure for said conductive element, which is configured to be straighten out at least partially during stretching said device.

In addition the supporting structure is coupled together with said conductive element between first and second outer layers of the device, where said first and second layers are advantageously for example textile, fabric, elastic or stretchable coating or film or other advantageously wearable material. As an example at least portion of the layer(s) may comprise also ESD (Electrostatic discharge) material in order to electrically protect the conductive elements inside the device and thereby enhancing signal transmission quality by minimizing outer interference.

According to the embodiment the coupling of said supporting structure with said conductive element to the device (and to the first and second outer layers) is implemented by providing an attaching rim portion (e.g. film adhesive framing) so said attaching rim portion surrounds the supporting structure with said conductive element and thereby forms the device. The attaching rim portion may be provided for example by integrating, such as laminating, sewing and/or gluing said first and second outer layers together in the rim portion surrounding said supporting structure with said conductive element, but not directly fixing said supporting structure with said conductive element to the outer layers. This ensures and maximises the stretchability of the supporting structure with said conductive element, because they can essentially freely move inside the structure, and thus the stretchability of the whole device. Of course the stretchability of the whole device depends also on the stretchability of the outer layers.

The stretchability of the supporting structure can be manipulated by the numbers of the openings or cuts or the like as well as with the thickness of the supporting structure. The more the openings the more stretchable the supporting structure. In addition it is to be noted that by cutting of the supporting structure a certain anatomical shaping can be achieved, such as an arc imitating a body form, like a back of a hand, neck, head, forehead or chest, as examples.

Furthermore it is to be noted that the structure of the device may be formed so to provide pressure against a measuring surface when the device is worn by the users, such as by providing the device essentially flat in its first side and 3D in other side or additionally cutting the supporting structure so to cause torque and there provide suitable pressure and additionally enhance better fitting or contact with the measuring surface or body where the device is worn.

Additionally, according to an example, the conductive element may be provided into the supporting structure so that said conductive element forms at least a partial loop over itself (such as a clover leaf) in order to change direction of the traction of the conductive element in the device (twisted form). This is because the conductive element, such as especially the circuit board is very rigid in its side direction and thus it is at least impossible to bend or stretch it in side direction.

The present invention offers advantages over the known prior art, such as very soft, adaptive and comfortable, as well as visually nice, stretchable device, which can be easily worn by the user. Especially the stretchability of the device can be easily maximizes by providing openings to the supporting structure and reeving the conductive element from side to side of the supporting structure via said openings and thereby providing corrugations to the conductive element. According to the invention the conductive element can be coupled with said supporting structure without any mechanical or chemical attaching, which makes the manufacturing process of the device very fast and inexpensive.

In addition the supporting structure decreases the stress caused to the conductive element during bending, which again extends the life time of the device. The supporting structure, such as soft foam or covering spacer with the openings for example, encapsulates the rigid conductive element, such as circuit board, and thereby shapes the conductive element during extension very smoothly suiting the shape of the openings of the supporting structure, and thus preventing existence of any sharp angles or bending in the conductive element. This (the openings and supporting structure) also supports the conductive element in the change of traction, where the conductive element is twisted around itself to change the traction of the device in the side direction of the conductive element.

The overall stretchability of the device can be adjusted by for example selecting the material of the outer layers in an appropriate way. Advantageously the outer layers are of stretchable material, but they can be selected so to limit the overall stretchability of the device so that the stretchability of the supporting structure and/or the conductive elements is not exceeded.

Furthermore the device can be manufactured to be anatomically shaped, which additionally makes the device very comfortable to use.

### BRIEF DESCRIPTION OF THE DRAWINGS

Next the invention will be described in greater detail with reference to exemplary embodiments in accordance with the accompanying drawings, in which:
- Figures 1A-K: illustrate exemplary embodiments of a stretchable device for transmitting signal according to an advantageous embodiment of the invention,
- Figures 2A: illustrate a principle (side view) of an exemplary stretchable device for transmitting signal according to an advantageous embodiment of the invention, and
- Figures 2B: illustrate a principle (top view) of an exemplary stretchable device for transmitting signal according to an advantageous embodiment of the invention.

### DETAILED DESCRIPTION

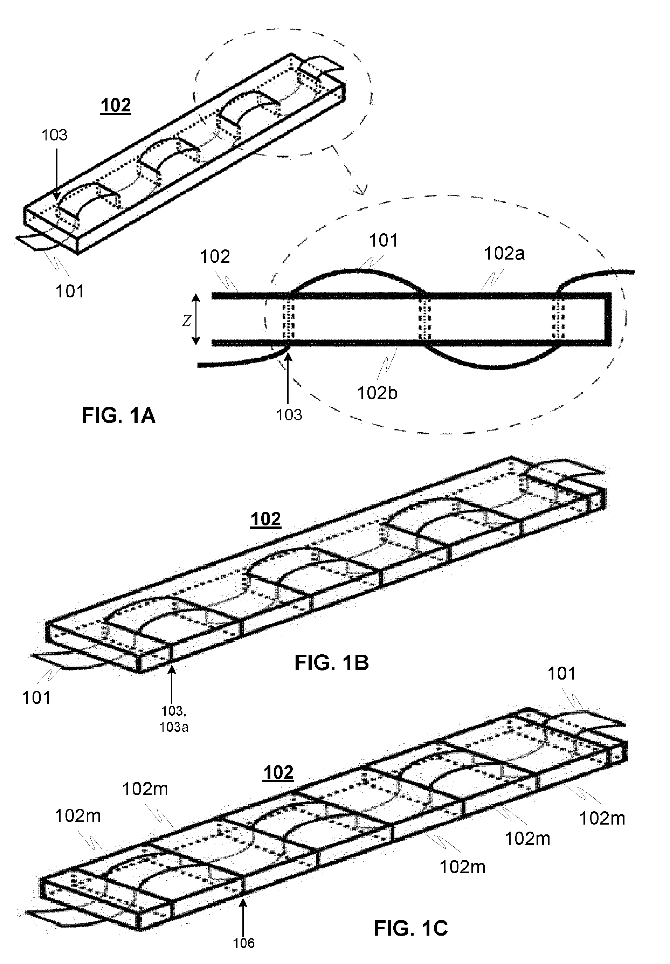

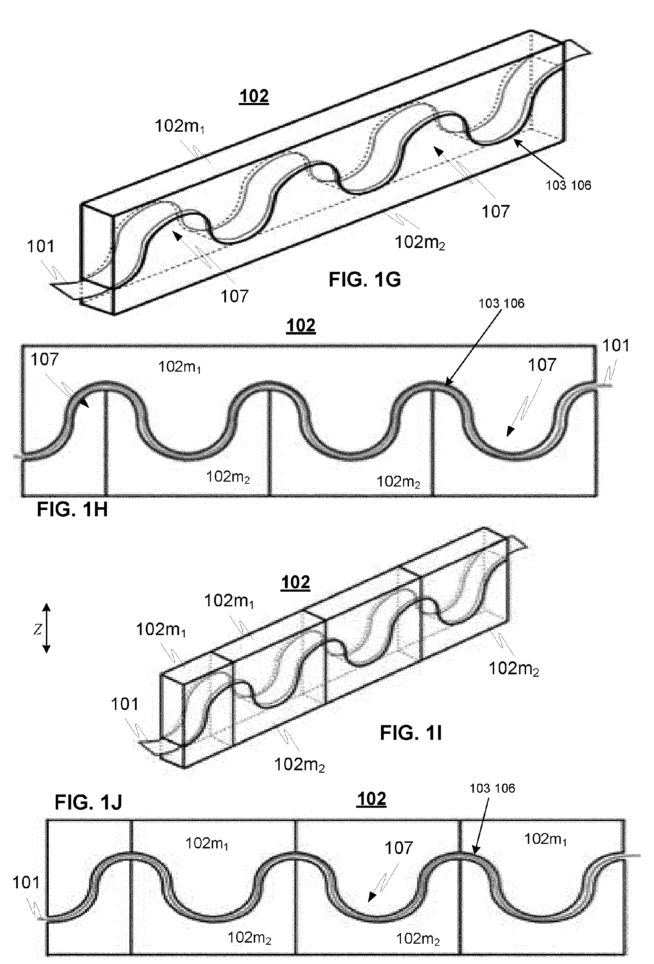

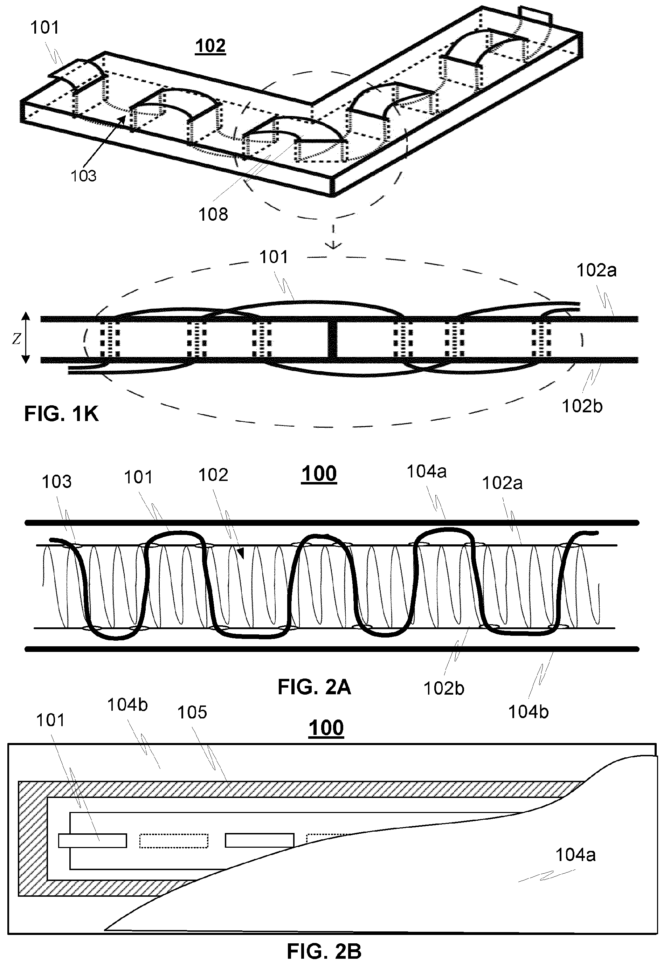

Figures 1A-1K illustrate exemplary embodiments of stretchable devices 100 for transmitting signal, and Figures 2A-2B illustrate principle embodiments of a wearable stretchable device 100 with covering layers according to advantageous embodiments of the invention.

The device 100 comprises a conductive element 101, such as conductor, circuit board, electric wire or cable or optical fibre or the like, and a supporting structure 102 for supporting said conductive element, such as a spacer or foam or the like. The supporting structure might be stretchable as such, or alternatively or additionally it may be manipulated to be stretchable, such as making suitable openings 103, cuts, grooves or other incisions 103a into the material of the supporting structure.

According to an embodiment the conductive element 101 may be coupled with the supporting structure 102 by introducing the conductive element 101 successively or alternately in a cross direction Z through a thickness of the supporting structure towards a first 102a and second side 102b of the supporting structure.

As can be seen in Figures 1A-F and 1K the conductive element 101 is coupled with the supporting structure 102 by reeving the conductive element 101 successively through the whole supporting structure to the first and second sides 102a, 102b of the supporting structure.

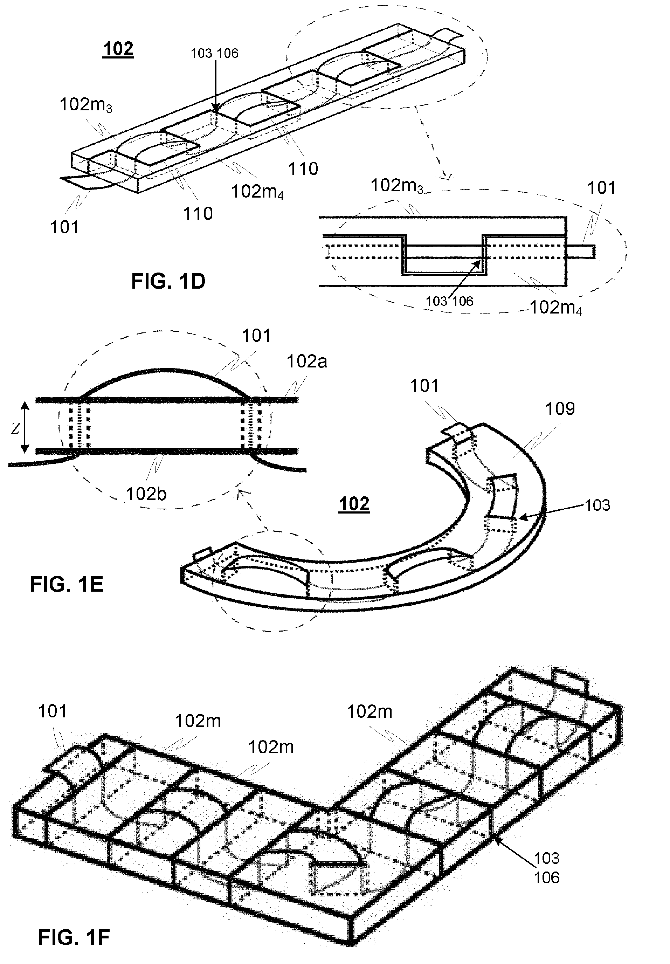

As is illustrated in exemplary Figures 1A, 1B, 1D, 1E, 1K and 2A, the supporting structure 102 are provided with openings or cuts 103 extending through the whole thickness Z of the supporting structure to the first and second side 102a, 102b of said supporting structure. The conductive element 101 is introduced successively through the whole thickness of the supporting structure to the first and second side 102a, 102b via said openings or cuts 103. The openings 103 may be provided either to a certain area in the supporting structure, as is illustrated e.g. in Figures 1A, 1E, 1K, or the openings or cuts 103, 103a may extend to at least one edge or border area of the in the supporting structure, as is illustrated e.g. in Figure 1B.

As is illustrated in exemplary Figures 1C, 1D, and 1F-1J, the supporting structure 102 may comprise a number of structure members 102m, which are coupled together so to form the supporting structure 102. The conductive element 101 can then be introduced successively from side to side 102a, 102b of the supporting structure via the joints 106 between the structure members coupled with each other.

The supporting structure may be formed also of at least two structure members 102m₁, 102m₂ coupled together so to form the supporting structure 102, as is illustrated in Figures 1G-1J, for example, where the joint surfaces 106 of the structure members 102m₁, 102m₂ comprises protrusions 107 and corresponding grooves essentially in the cross direction through the thickness Z of the supporting structure 102 advantageously towards the first and second sides 102a, 102b of the supporting structure. The conductive element 101 can then be arranged into the joint area 106 between the structure members 102m and thereby providing a corrugated structure for said conductive element, which is configured to be straighten out at least partially during stretching the device 100, 102.

In addition, according to an embodiment the supporting structure may be formed also of at least two structure members 102m₃, 102m₄, where the structure members both are a comb like, whereupon they can be coupled with each other in overlapping manner, as is illustrated in Figure 1D. In this case the conductive element 101 can be introduced successively in each side of the comb structure via the joint between the structure members, so over the peaks 110 of the comb structures.

Additionally, according to an example, the conductive element 101 may be provided into the supporting structure 102 so that said conductive element forms at least a partial loop 108 over itself (such as a clover leaf) in order to change a direction of the traction of the conductive element 101 in the device (twisted form), as is especially described in Figures 1F and 1K. In addition it is to be noted that by cutting of the supporting structure 102 in a suitable way (e.g. by providing incisions) a certain anatomical shaping 109 can be achieved, as is especially described in Figure 1E.

According to an embodiment the device 100 comprises also first 104a and/or second 104b outer layers between which the supporting structure 102 is provided together with said conductive element 101, as can be seen in Figures 2A, 2B. The coupling of the supporting structure 102 together with said conductive element 101 to the outer layers 104a, 104b may be implemented e.g. by providing an attaching rim portion 105 (e.g. film adhesive framing) so said attaching rim portion 105 surrounds the supporting structure 102 with said conductive element 101. In the figure 2B the adhesive film framing 105 is provided on the surface of second layer 104b and the first layer is then attached via said adhesive film framing 105 in order to encapsulate the supporting structure 102 with said conductive element 101 and to form an exemplary wearable device 100.

The invention has been explained above with reference to the aforementioned embodiments, and several advantages of the invention have been demonstrated. It is clear that the invention is not only restricted to these embodiments, but comprises all possible embodiments within the spirit and scope of the inventive thought and the following patent claims. Especially it is to be noted that this document does not limit the usage of the device to a certain type of sensors, but the stretchable device according to the invention can be applied freely in signal transmission or electric supply. The device may be used as wearable device and it can be worn freely on different portions of body, such as arm, back of a hand, neck, head, forehead or chest, as examples.

## Claims

1. A stretchable device (100, 102) for transmitting signal between two points of the device,
wherein the device comprises:
- a supporting structure (102) extending between said two points, said supporting structure having thickness essentially in a cross direction (Z) to a line between said two points,
- a conductive element (101),
- wherein said conductive element is coupled with said supporting structure by introducing said conductive element successively in the direction of the thickness (Z) of said supporting structure towards a first (102a) and second (102b) side of said supporting structure, thereby providing a corrugated structure for said conductive element (101), which is configured to be straighten out at least partially during stretching said device (100, 102).

2. A device according to claim 1, wherein the supporting structure (102) comprises spacer or foam, which is stretchable as such or configured to be stretchable by providing cuts (103) at least on one side of said supporting structure.

3. A device according to claim 1, wherein the supporting structure comprises openings or cuts (103, 103a) extending through the whole thickness (Z) of said supporting structure to the first (102a) and second (102b) side of said supporting structure and wherein said conductive element is introduced successively through the whole thickness (Z) of said supporting structure to the first and second side of said supporting structure via said openings or cuts (103, 103a).

4. A device according to claim 1, wherein the supporting structure comprises a number of structure members (102ₘ), which are coupled together so to form said supporting structure, and wherein the conductive element is introduced successively from side to side of said supporting structure via the joints (106) between the structure members coupled with each other.

5. A device according to claim 1, wherein the supporting structure comprises at least two structure (102ₘ₁, 102ₘ₂) members coupled together so to form said supporting structure, where joint surfaces (106) of said structure members comprises protrusions (107) essentially in the cross direction through the thickness (Z) of said supporting structure, and where the conductive element is arranged into the joint (103, 106) between said structure members and thereby providing a corrugated structure for said conductive element, which is configured to be straighten out at least partially during stretching said device.

6. A device according to claim 1, wherein said conductive element (101) is a circuit board, conductor, electric wire or cable or optical fibre.

7. A device according to claim 1, wherein said device comprises a first and/or second outer layer (104a, 104b) arranged around the device, and wherein said and/or second outer layer is textile, fabric, or elastic or stretchable coating or film, or layer comprising ESD (Electrostatic discharge) material.

8. A device according to claim 7, wherein the supporting structure (102) is arranged between said first and second outer layers (104a, 104b) so that the structure of the device is essentially flat in its first side and 3D in other side and thereby said structure is configured to provide pressure against a measuring surface.

9. A device according to claim 1, wherein the supporting structure is shaped in an anatomical form of a body.

10. A device according to claim 1, wherein the supporting structure with said conductive element is integrated, such as laminated, into first and second outer layers.

11. A device according to claim 10, wherein the supporting structure (102) with said conductive element (101) is integrated to the device (100) so that said the first and second outer layers (104a, 104b) are attached, such as laminated, to each other by an attaching rim portion (105) so said attaching rim portion surrounds the supporting structure with said conductive element.

12. A device according to claim 1, wherein the conductive element comprises portion, which is arranged in to the supporting structure so that said conductive element forms at least a partial loop (108) during said portion in order to change direction of the traction of the conductive element in the device.

13. A device according to claim 1, wherein the device comprises an electric unit and/or a sensor, wherein the sensor is a pulse meter or pulse oximeter, EEG sensor, temperature sensor or acceleration sensor.

14. A method for manufacturing a stretchable device (100, 102) for transmitting signal between two points,
wherein the method comprises steps of:
- providing a supporting structure (102) extending between said two points, said supporting structure having thickness (Z) essentially in a cross direction to a line between said end points, and
- coupling a conductive element (101) with said supporting structure by introducing said conductive element successively in the direction of the thickness (Z) of said supporting structure towards a first and second side (102a, 102b) of said supporting structure, thereby providing a corrugated structure for said conductive element, which is straighten out at least partially during stretching said device.
